Europäisches Patentamt

European Patent Office

Office européen des brevets

(19)

(11) Numéro de publication : **0 417 682 B1**

(12) **FASCICULE DE BREVET EUROPEEN**

(45) Date de publication du fascicule du brevet :
08.12.93 Bulletin 93/49

(51) Int. Cl.⁵ : **H03L 7/10**

(21) Numéro de dépôt : **90117358.3**

(22) Date de dépôt : **10.09.90**

(54) **Transpondeur de mise à poste d'un satellite.**

(30) Priorité : **14.09.89 FR 8912043**

(43) Date de publication de la demande :
**20.03.91 Bulletin 91/12**

(45) Mention de la délivrance du brevet :
**08.12.93 Bulletin 93/49**

(84) Etats contractants désignés :
**DE ES FR GB IT**

(56) Documents cités :
**EP-A- 0 051 473**
**US-A- 4 513 447**

(73) Titulaire : **ALCATEL ESPACE**
**11, avenue Dubonnet**
**F-92407 Courbevoie Cédex (FR)**

(72) Inventeur : **Foucher, Jean-Luc**
**120 Chemin de la Longue**
**F-31600 Seysses (FR)**
Inventeur : **Atge, Marc**
**24, rue Rodolose**
**F-31300 Toulouse (FR)**
Inventeur : **Rousselet, Dominique**
**47 Chemin de Riyalsupervic, Bât C - App 16**
**F-31400 Toulouse (FR)**
Inventeur : **Tonello, Emile**
**4, rue Edith Piaf**
**F-31100 Toulouse (FR)**
Inventeur : **Triaud, Pascal**
**8, rue de l'Isère**
**F-31170 Tournefeuille (FR)**

(74) Mandataire : **Weinmiller, Jürgen et al**
**Lennéstrasse 9 Postfach 24**
**D-82336 Feldafing (DE)**

## Description

L'invention concerne un transpondeur de mise à poste d'un satellite, et plus particulièrement un transpondeur bande S d'un satellite de type "TELECOM II"

En effet dans un satellite, la surveillance du bon fonctionnement du véhicule et de la charge utile est nécessaire en permanence. Pour cela, le système de télémesure télécommande et localisation permet au centre de contrôle d'assurer ce service grâce à l'envoi par le satellite d'informations télémesurées ; le centre de contrôle assure la gestion par l'envoi d'ordres de télécommande. La localisation permet d'obtenir les données nécessaires pour connaître la position du satellite en mise et maintien à poste. Le système utilise soit une bande de fréquence particulière, en général la bandes, notamment à la mise à poste, soit une bande de télécommunications utilisée pour la mission nominale.

Un manuel de Floyd M. GARDNER intitulé "Phaselock Techniques" (John Wiley and Sons ; seconde édition page 163, figure 8-12) décrit un transpondeur de l'art connu.

L'invention a pour objet de réaliser un transpondeur plus performant et moins cher que ceux de l'art connu.

L'invention propose, à cet effet, un transpondeur de mise à poste d'un satellite, caractérisé en ce que l'oscillateur local du récepteur est asservi sur un pilote à quartz par une boucle de phase à bande étroite en période d'attente ou en l'absence de signal reçu, et en ce que cet oscillateur local est asservi sur le signal d'entrée du récepteur par une boucle de phase à bande plus large dès réception du signal, la boucle de phase à bande étroite étant alors coupée automatiquement.

Avantageusement dans ce transpondeur l'émetteur est à la même fréquence que l'oscillateur local du récepteur en mode cohérent, en étant stabilisé par une boucle de phase identique au niveau plan de fréquence et composants à la boucle de phase étroite.

Un tel transpondeur présente notamment, les avantages suivants :
- Une diminution du coût et du cycle de réalisation de l'équipement récepteur + émetteur;
- Une meilleure stabilité long terme de la fréquence de repos du récepteur;
- Une insensibilité aux phénomènes de "pushing" du récepteur;
- Une amélioration de la stabilité de la boucle de phase du récepteur.

L'invention permet donc :
- d'utiliser le même plan de fréquence pour l'émetteur et la génération de l'oscillateur local du récepteur,
- d'utiliser deux boucles de phase dans le récepteur, gérées par un système automatique de commutation :

. Une boucle de phase à bande étroite qui assure la stabilité long terme et permet de supprimer les effets indésirables du "Pushing" pendant la phase d'acquisition de la porteuse.

. Une boucle de phase à bande plus large, qui assure l'accrochage et le maintien sur la porteuse montante, permettant ainsi de démoduler le signal montant.

. Un indicateur d'accrochage qui coupe automatiquement la boucle étroite dès que la boucle large est accrochée sur la porteuse montante, et la remet en service en cas de décrochage.

. Aucun oscillateur à quartz commandable en tension n'est utilisé : pour éviter tout pôle parasite dans la boucle large (amélioration de sa stabilité) ; un tel élément étant, de plus, délicat à réaliser (entraînant de long délais d'approvisionnement) et coûteux.

. On utilise des diviseurs de fréquence sous forme de composants plutôt que des multiplicateurs de fréquence: modules complexes très délicats et longs à produire (ils doivent être suivis d'un filtrage sévère lorsque le rang de multiplication est élevé).

Les caractéristiques et avantages de l'invention ressortiront d'ailleurs de la description qui va suivre, à titre d'exemple non limitatif, en référence aux figures annexées sur lesquelles :
- la figure 1 illustre un transpondeur de l'art connu ;
- la figure 2 illustre le transpondeur selon l'invention.

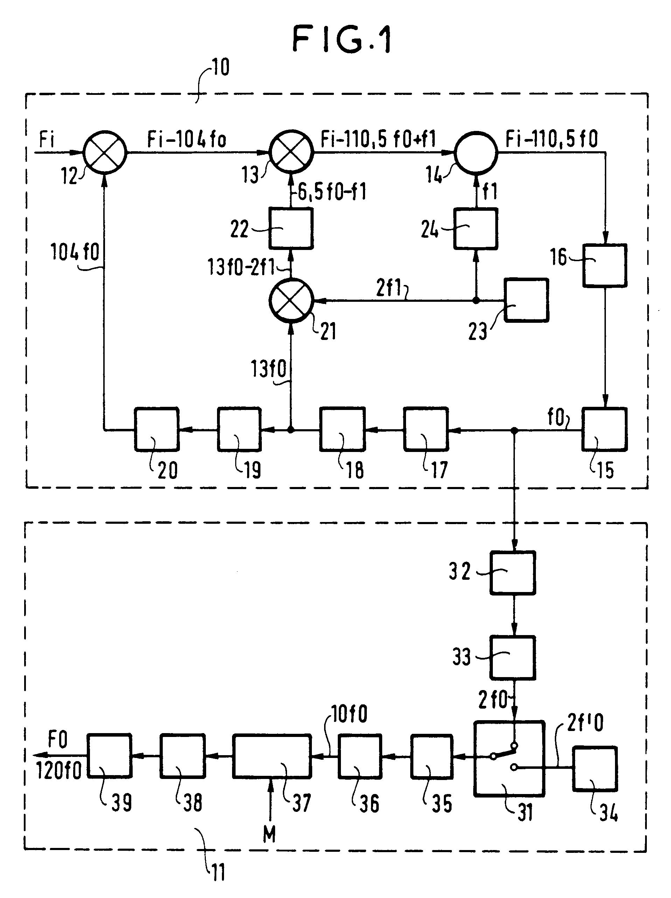

Le transpondeur de l'art connu (voir références données en préambule de la description) représenté à la figure 1 comprend un récepteur 10 et un émetteur 11.

Dans la suite de la description les principaux signaux sont référencés par leur valeur en fréquence.

Dans le récepteur 10 :
- un premier mélangeur 12 reçoit une fréquence d'entrée Fi et une fréquence 104 fo ;
- un second mélangeur 13 reçoit le signal de sortie du premier mélangeur, soit Fi-104 fo, et un signal 6,5 fo-f1,
- un comparateur de phase 14 reçoit le signal de sortie de ce second mélangeur 13 et un signal f1. Le signal de sortie de celui-ci permet de commander un oscillateur à quartz commandable en tension 15 (OQCT) via un filtre de boucle 16. Cet oscillateur 15 permet de délivrer :

. le signal 104 fo du premier mélangeur 12 via un premier multiplicateur (17) par 13 suivi d'un filtre 18, et d'un second multiplicateur (19) par 8 suivi d'un filtre 20 ;

. le signal 6,5 fo-f1 au travers du premier multiplicateur 17 suivi de son filtre 18 associé, d'un troisième mélangeur 21 et d'un diviseur (22) par 2 un oscillateur à quartz 23, délivrant un signal 2f1, étant relié directement à ce troisième mélangeur 21, et au comparateur de phase 14 au travers d'un diviseur (24) par 2.

Dans l'émetteur 11 :
- un interrupteur 31 reçoit :
  . une voie cohérente constituée par le signal de sortie de l'oscillation à quartz commandable en tension 15 après passage dans un multiplicateur (32) par 2 et dans un filtre 33 ;
  . une voie non cohérente constituée par un oscillateur à quartz 34 délivrant un signal 2f'o.
- le signal de sortie de l'émetteur Fo est le signal de sortie de cet interrupteur 31 au travers d'un multiplicateur (35) par 5 suivi d'un filtre 36, du modulateur 37 qui reçoit le signal de modulation M, d'un multiplicateur 38 par 12 suivi d'un filtre 39.

Dans le synoptique du récepteur 10 le pilote à quartz 23 à 2f1 n'intervient pas dans les paramètres de la boucle de phase, il sert à obtenir une seconde fréquence intermédiaire fixe à f1 quand le récepteur 10 est accroché.

Le coeur du récepteur est l'oscillateur à quartz commandable en tension 15 (OQCT) à fo.

Quand le récepteur 10 est accroché, la fréquence de l'OQCT 15 suit la fréquence d'entrée Fi de telle sorte que : 110.5 fo = Fi.

Quand le récepteur 10 n'est pas accroché, il assure la stabilité de la fréquence de repos du récepteur qui est égale à 110,5 fo (repos). Cette fréquence de repos est donc affectée par la stabilité de la tension de commande en l'absence de porteuse à l'entrée.

Ce montage est de plus sujet au "pushing" : En effet lorsque du sol on balaye en fréquence une porteuse, le récepteur s'accroche lorsque la fréquence de cette porteuse passe sur sa fréquence de repos. Certains phénomènes peuvent alors apparaître pendant cette phase d'accrochage. Sous certaines conditions une tension tendant à éloigner l'oscillateur à quartz commandable en tension de l'accrochage peut apparaître (au lieu de l'en rapprocher). Le phénomène peut être gênant lorsque le balayage de la porteuse montante est lent : L'oscillateur peut alors aller en butée et empêcher l'accrochage du récepteur.

Dans ce synoptique sont utilisés deux multiplicateurs de fréquence 17 et 19 de réalisation difficile et nécessitant des filtrages sévères 18 et 20 :
- un multiplicateur par 13 : fo→13 fo
- un multiplicateur par 8 : 13 fo→104 fo.

L'OQCT 15 pose, de plus, certains problèmes : du fait de réponses fréquentielles parasites proches (antirésonnance du quartz) on doit diminuer la boucle de modulation pour ne pas les exciter. Ceci a pour effet d'introduire un pôle parasite supplémentaire dans la boucle du récepteur.

Dans l'émetteur 11 le pilote à quartz 34 à 2 f'o est utilisé comme référence en mode non cohérent.

Il est encore fait appel à des multiplicateurs de fréquence 32, 35 et 38 de réalisation difficile :
- un multiplicateur par 2 : f→2 fo
- un multiplicateur par 5 : 2 fo→10 fo
- un multiplicateur par 12 : 10 fo→120 fo.

La modulation se fait sur la porteuse à 10 fo.

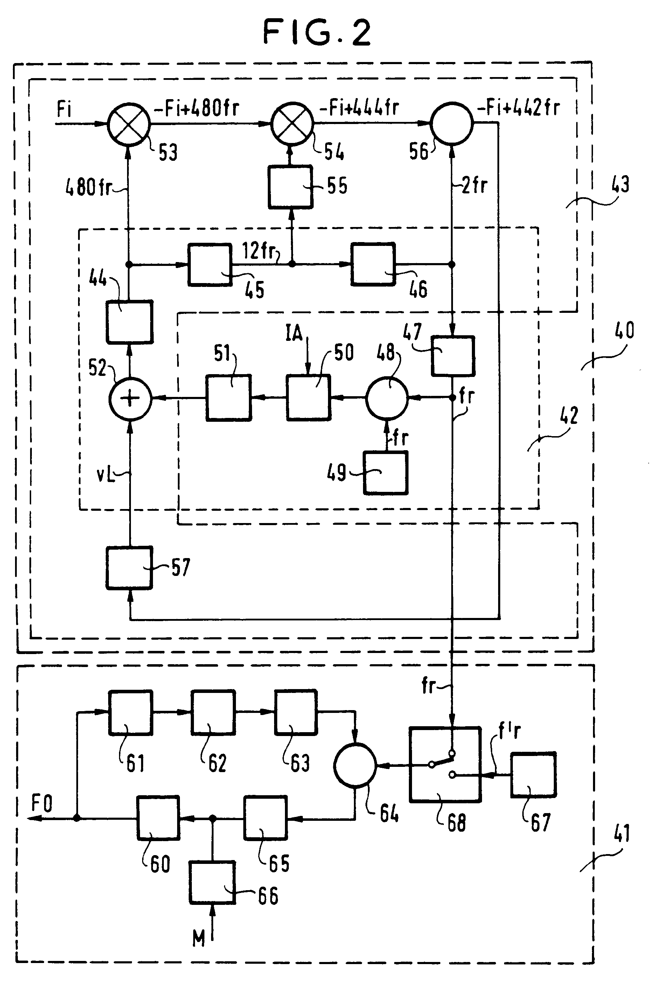

Sur la figure 2 est représenté le transpondeur de l'invention avec sa partie récepteur 40 et sa partie émetteur 41.

Le récepteur 40 comporte :
- une boucle de phase à bande étroite 42 qui comprend un oscillateur commandé en tension 44 (OCT) délivrant un signal à la fréquence 480 fr, un diviseur (45) par 40, un diviseur (46) par 6, un diviseur (47) par 2, un comparateur phase/fréquence 48 recevant d'une part le signal issu du diviseur (47) par 2, et d'autre part un signal fr issu d'un pilote à quartz 49, un interrupteur 50 recevant un signal de commande IA, un filtre de boucle 51 et un sommateur 52.
- une boucle de phase à bande large 43 qui comprend plusieurs circuits appartenant déjà à la boucle de phase à bande étroite 42, à savoir le sommateur 52, l'oscillateur commandé en tension 44, et les diviseurs (45) par 40 et (46) par 6 et de nouveaux circuits, à savoir : un premier mélangeur 53 qui reçoit d'une part le signal d'entrée Fi et d'autre part le signal issu de l'oscillateur commandé en tension 44, suivi d'un second mélangeur 54 qui reçoit le signal issu du diviseur (45) par 40 après multiplication par 3 (55), suivi d'un comparateur de phase 56 qui reçoit le signal issu du diviseur (46) par 6 et dont la sortie est reliée au sommateur 52 via un filtre de boucle 57.

En sortie du premier mélangeur 53 on a donc un signal :
-Fi + 480 fr, en sortie du second mélangeur 54 : - Fi + 444 fr et en sortie du comparateur de phase 56 : - Fi + 442 fr. Cette boucle large a donc pour objet de maintenir la condition :
Fi = 442 fr.

L'émetteur 41 se compose des mêmes éléments que la boucle de phase en bande étroite, à savoir un oscillateur commandé en tension 60, un diviseur (61) par 40, un diviseur (62) par 6, un diviseur (63) par 2, un comparateur phase/fréquence 64 et un filtre de boucle 65 relié à l'oscillateur 60.

Il comporte de plus :
- un dérivateur 66 pour la modulation de phase hors bande de boucle,
- un oscillateur à quartz 67 et un interrupteur 68 pour le fonctionnement en mode cohérent (liaison au récepteur 40), ou en mode non cohérent (liaison à l'oscillateur 67). On constate que le plan de fréquence de cet émetteur est identique à celui de la génération d'oscillateur local du récepteur : ceci réduit les coûts d'étude et de réalisation des deux ensembles (composants identiques, réglages similaires).

Dans ce synoptique, lorsque le récepteur 40 n'est pas accroché, la boucle à bande étroite 42 est en service et asservit l'oscillateur commandable en tension 44 sur le pilote à quartz 49 très stable.

Cette boucle 42 compense les variations éventuelles de la tension de commande vL issue de la boucle large 43. D'où une très bonne stabilité de la fréquence de repos du récepteur 40.

De plus cette boucle 42, pendant la phase d'accrochage du récepteur 40, compense les offsets de "pushing" qui pourraient repousser l'oscillateur 44 au lieu de l'attirer vers l'accrochage.

La boucle à bande large 43 permet l'accrochage du récepteur 40 sur la fréquence montante Fi et délivre un indicateur d'accrochage (IA) qui coupe automatiquement la boucle à bande étroite 42 à l'aide de son interrupteur 50.

On note que les multiplicateurs de fréquence 17 et 19 (respectivement par 13 et par 8) du synoptique représenté à la figure 1 ont été remplacés par des diviseurs 45 et 46 (respectivement par 40 et 6) par exemple de type ECL.

Le multiplicateur par 3 (55) est en fait fictif : il fait partie du mélangeur 54 (mélangeur harmonique).

De plus l'OQCT 15 de la figure 1 a été remplacé par un OCT 44 à 480 fr et un pilote à quartz 49 à fr. Ces deux modules sont beaucoup plus simples, pris séparément.

Le récepteur de l'invention 40 représenté à la figure 2, est dit à boucle de phase longue car il fait appel à deux fréquences intermédiaires qui sont dans la boucle.

Sans porteuse à l'entrée, le récepteur 40 est en attente. Sa fréquence de repos correspond à la fréquence qu'il faudrait appliquer à l'entrée pour qu'il s'accroche instantanément.

Ce récepteur 40 fournit un indicateur d'accrochage IA. Cette information est envoyée au sol et sert à la gestion de l'émetteur 41.

La porteuse de l'émetteur doit pouvoir être modulée en phase. Il a deux modes de fonctionnement :
- Mode cohérent :

$$Fo = \frac{240}{221} Fi$$

Fo : fréquence d'émission.
Fi : fréquence de réception.
Ainsi l'émetteur utilise la référence issue du récepteur à

$$fr = k \frac{Fi}{221}$$

- Mode non cohérent.
     Le pilote à quartz 67 interne à l'émetteur sert alors de référence.

Dans un exemple de réalisation on a obtenu les valeurs suivantes :
- Récepteur :

$$fr = \frac{Fi}{442} \qquad Fi \simeq 2GHz$$

soit : fr $\simeq$ 4,5 MHz
Boucle à bande étroite : bande de bruit : $2B_e$ = 20 Hz
Boucle à bande large : bande de bruit = $2B_l$ 800 Hz
l'OCT 44 a pour fréquence de repos : Fr = 480 fr = 2,17 GKZ
- Emetteur :
       fo $\simeq$ 2,17 GHz
       f'r $\simeq$ 4,5 MHz

Boucle de modulation : bande de bruit = 2B $\simeq$ 1000.Hz.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1. Transpondeur de mise à poste d'un satellite, caractérisé en ce que l'oscillateur local (44) du récepteur (40) est asservi sur un pilote à quartz (49) par une boucle de phase à bande étroite (42) sen période d'attente ou en l'absence de signal reçu, et en ce que cet oscillateur local (44) est asservi sur le signal d'entrée du récepteur par une boucle de phase à bande plus large (43) dès réception du signal, la boucle de phase à bande étroite (42) étant alors coupée automatiquement.

2. Transpondeur selon la revendication 1, caractérisé en ce que l'émetteur (41) est à la même fréquence que l'oscillateur local (44) du récepteur en mode cohérent, en étant stabilisé par une boucle de phase identique au niveau plan de fréquence et composants à la boucle de phase à bande étroite (42).

3. Transpondeur selon l'une quelconque des revendications 1 ou 2, caractérisé en ce que les fréquences de référence sont délivrées par deux oscillateurs à quartz (49, 67) à basse fréquence, toutes les autres fréquences étant obtenues par division et comparées à ces fréquences références en mode attente pour le récepteur et en mode non cohérent pour l'émetteur.

4. Transpondeur selon l'une quelconque des revendications précédentes, caractérisé en ce qu'il comprend qu'un multiplicateur (55) contenu implicitement dans un mélangeur harmonique de rang 3.

5. Transpondeur selon la revendication 1, caractérisé en ce que le récepteur (40) comporte :
   - une boucle de phase à bande étroite (42) qui comprend un oscillateur commandé en tension (44) délivrant un signal 480 fr, un diviseur (45) par 40, un diviseur (46) par 6, un diviseur (47) par 2, un comparateur phase/fréquence (48) recevant d'une part le signal issu du diviseur (47) par 2, et d'autre part un signal fr issu d'un pilote à quartz (49), un interrupteur (50) recevant un signal de commande IA, un filtre de boucle (51) et un sommateur (52) ;
   - une boucle de phase à bande large (43) qui comprend plusieurs circuits appartenant déjà à la boucle de phase à bande étroite (42), à savoir le sommateur (52), l'oscillateur commandé en tension (44), et les diviseurs (45) par 40 et (46) par 6 et de nouveaux circuits, à savoir : un premier mélangeur (53) qui issu de l'oscillateur commandé en tension (44), suivi d'un second mélangeur (54) qui reçoit le signal issu du diviseur (45) par 40 après multiplication par 3 (55), suivi d'un comparateur de phase (56) qui reçoit le signal issu du diviseur (46) par 6 et dont la sortie est reliée au sommateur (52) via un filtre de boucle (57).

6. Transpondeur selon la revendication 2, caractérisé en ce que l'émetteur (41) se compose des mêmes éléments que la boucle de phase en bande étroite, à savoir un oscillateur commandé en tension (60), un diviseur (61) par 40, un diviseur (62) par 6, un diviseur (63) par 2, un comparateur phase/fréquence (64) et un filtre de boucle (65) relié à l'oscillateur (60), et comporte de plus :
   - un dérivateur (66) pour la modulation de phase hors bande de boucle,
   - un oscillateur à quartz (67) et un interrupteur (68) pour le fonctionnement en mode cohérent (liaison au récepteur (40)), ou en mode non cohérent (liaison à l'oscillateur (67)).

7. Transpondeur selon l'une quelconque des revendications précédentes, caractérisé en ce que ledit transpondeur est un transpondeur bande S.

**Patentansprüche**

1. Transponder zur Positionierung eines Satelliten, dadurch gekennzeichnet, daß der örtliche Oszillator (44) des Empfängers (40) auf einen Quarzoszillator (49) durch eine schmalbandige Phasenschleife (42) in einer Warteperiode und bei Abwesenheit eines Empfangssignals nachgeregelt wird und daß dieser örtliche Oszillator (44) auf das Eingangssignal des Empfängers durch eine breitbandige Phasenschleife (43) bei Vorliegen eines Empfangssignals abgestimmt wird, wobei dann die schmalbandige Phasenschleife (42) automatisch unterbrochen wird.

2. Transponder nach Anspruch 1, dadurch gekennzeichnet, daß der Sender (41) bei derselben Frequenz wie der örtliche Oszillator (44) des Empfängers im kohärenten Modus betrieben wird, wobei er durch eine gleiche Phasenschleife stabilisiert wird, was die Frequenzwerte und Bauteile der schmalbandigen Phasenschleife (42) angeht.

3. Transponder nach einem beliebigen der Ansprüche 1 oder 2, dadurch gekennzeichnet, daß die Bezugsfrequenzen von zwei Quarzoszillatoren (49, 67) niedriger Frequenz geliefert werden, während alle anderen Frequenzen durch Teilen und Vergleichen dieser Bezugsfrequenzen im Wartemodus, was den Empfänger angeht, und im nicht kohärenten Modus, was den Sender angeht, erhalten werden.

4. Transponder nach einem beliebigen der vorhergehenden Ansprüche, dadurch gekennzeichnet, daß er einen Multiplizierer (55) enthält, der implizit in einer harmonischen Mischstufe des Rangs 3 enthalten ist.

5. Transponder nach Anspruch 1, dadurch gekennzeichnet, daß der Empfänger (40) aufweist:
   - eine schmalbandige Phasenschleife (42), die einen ein Signal 480fr liefernden spannungsgesteuerten Oszillator (44), einen durch den Wert 40 teilenden Teiler (45), einen durch den Wert 6 teilenden Teiler (46), einen durch den Wert 2 teilenden Teiler (47), einen Phasen-/Frequenzkomparator (48), der einerseits das Ausgangssignal des Teilers (47) durch den Wert 2 und andererseits ein von einem Quarzoszillator (49) kommendes Signal fr empfängt, einen ein Steuersignal IA empfangenden Schalter (50), ein Schleifenfilter (51) und ein Summierglied (52) enthält,
   - eine breitbandige Phasenschleife (43), die mehrere bereits der schmalbandigen Phasenschleife (42) angehörende Schaltungen, nämlich das Summierglied (52), den spannungsgesteuerten Oszillator (44) und die Teiler (45 und 46) durch die Werte 40 bzw. 6, sowie weitere Schaltungen enthält, nämlich eine erste Mischstufe (53), die einerseits das Eingangssignal Fi und ande- rerseits das Ausgangssignal des span- nungsgesteuerten Oszillators (44) emp- fängt und von einer zweiten Mischstufe (54) gefolgt wird, die das Ausgangssignal des Teiles (45) durch den Wert 40 nach einer Multiplikation mit 3 (55) empfängt, weiter gefolgt von einem Phasenkomparator (56), der das Ausgangssignal des Teilers (56) durch den Wert 6 empfängt und dessen Ausgang mit dem Summierglied (52) über ein Schleifenfilter (57) verbunden ist.

6. Transponder nach Anspruch 2, dadurch gekennzeichnet, daß der Sender (41) dieselben Elemente wie die schmalbandige Phasenschleife ent- hält, nämlich einen spannungsgesteuerten Oszil- lator (60), einen Teiler (61) durch den Wert 40, einen Teiler (62) durch den Wert 6, einen Teiler (63) durch den Wert 2, einen Phasen-/Frequenzkomparator (64) und ein an den Oszillator (60) angeschlossenes Schleifenfilter (65) sowie außerdem
   - ein Ableitungsglied (66) für die Phasenmodulation außerhalb des Schleifenbandes,
   - einen Quarzoszillator (67) und einen Schalter (68) für den Betrieb im kohärenten Modus (Verbindung mit dem Empfänger (40)) oder im nicht kohärenten Modus (Verbindung mit dem Oszillator (67)).

7. Transponder nach einem beliebigen der vorhergehenden Ansprüche, dadurch gekennzeichnet, daß der Transponder ein Transponder im Band S ist.

## Claims

1. Satellite transponder characterised in that a local oscillator (44) of the receiver (40) is slaved to a quartz crystal oscillator (49) by a narrowband phase-locked loop (42) in a standby period or in the absence of received signal and said local oscillator (44) is slaved to the receiver input signal by a wideband phase-locked loop (43) immediately said signal is received, the narrowband phase-locked loop (42) being then switched out automatically.

2. Transponder according to claim 1 characterised in that the transmitter frequency is the same as the receiver local oscillator frequency in coherent mode, being stabilised by a phase-locked loop identical in terms of frequency scheme and components to said narrowband phase-locked loop (42).

3. Transponder according to claim 1 or claim 2 characterised in that the reference frequencies are supplied by two low-frequency quartz crystal oscillators (49, 67), all other frequencies being derived by division and compared with these reference frequencies, in standby mode in the case of the receiver and in non-coherent mode in the case of the transmitter.

4. Transponder according to any one of the preceding claims characterised in that it comprises a multiplier (55) constituted by one function of a third harmonic mixer.

5. Transponder according to claim 1 characterised in that the receiver (40) comprises:
   - a narrowband phase-locked loop (42) which includes a voltage-controlled oscillator (44) supplying a signal 480 fr, a divider (45) which divides by 40, a divider (46) which divides by 6, a divider (47) which divides by 2, a phase/frequency comparator (48) receiving the signal from the divider (47) which divides by 2 and a signal fr from a quartz crystal oscillator (49), a switch (50) receiving a command signal IA, a loop filter (51) and an adder (52);
   - a wideband phase-locked loop (43) which includes the following circuits which are also part of said narrowband phase-locked loop (42): said adder (52), said voltage-controlled oscillator (44) and said dividers (45, 46) which divide by 40 and by 6, together with the following further circuits: a first mixer (53) which receives the input signal Fi and the signal from said voltage-controlled oscillator (44), followed by a second mixer (54) which receives the signal from said divider (45) which divides by 40 after it is multiplied by 3 (55), followed by a phase comparator (56) which receives the signal from said divider (46) which divides by 6 and the output of which is connected to said adder (52) via a loop filter (57).

6. Transponder according to claim 2 characterised in that the transmitter (41) comprises the same components as the narrowband phase-locked loop, namely a voltage-controlled oscillator (60), a divider (61) which divides by 40, a divider (62) which divides by 6, a divider (63) which divides by 2, a phase/frequency comparator (64) and a loop filter (65) connected to the oscillator (60), and further comprises:
   - a differentiator (66) for loop out-band phase modulation,
   - a quartz crystal oscillator (67) and a switch (68) for operation in coherent mode (connected to the receiver (40)) or in non-coherent mode (connected to the oscillator (67)).

7. Transponder according to any one of the preceding claims characterised in that it is implemented as an S band transponder.

EP 0 417 682 B1

# F I G.1

8

# FIG.2